# FASCICULE DE BREVET EUROPEEN

(11) **EP 3 021 571 B1**
(45) Date de publication et mention de la délivrance du brevet: **09.11.2016**
(21) Numéro de dépôt: 15192628.4
(22) Date de dépôt: 02.11.2015
(51) Int. Cl.: H04N 5/374, H04N 5/378, H04N 5/3745, H03M 3/00

(54) **CAPTEUR D'IMAGES CMOS À CONVERSION ANALOGIQUE-NUMÉRIQUE DE TYPE SIGMA-DELTA**
CMOS-BILDSENSOR MIT ANALOG-DIGITAL-UMWANDLUNG VOM TYP SIGMA-DELTA
CMOS IMAGE SENSOR WITH SIGMA-DELTA ANALOGUE-TO-DIGITAL CONVERSION

(30) Priorité: 13.11.2014 FR 1460948
(43) Date de publication de la demande: 18.05.2016
(73) Titulaire: COMMISSARIAT A L'ENERGIE ATOMIQUE ET AUX ENERGIES ALTERNATIVES, 75015 Paris (FR)
(72) Inventeur: VERDANT, Arnaud, 38330 ST NAZAIRE LES EYMES (FR)
(74) Mandataire: Thibon, Laurent

(56) Documents cités:
- US-A- 5 886 659
- US-A1- 2010 177 213
- US-B1- 7 466 255
- SILVA P M ET AL: "Sigma-delta A/D converter for CMOS image sensors", MICROELECTRONICS (ICM), 2009 INTERNATIONAL CONFERENCE ON, IEEE, PISCATAWAY, NJ, USA, 19 décembre 2009 (2009-12-19), pages 94-97, XP031631820, ISBN: 978-1-4244-5814-1
- JOHANNES UHLIG ET AL: "A low-power continuous-time incremental 2nd-order-MASH [Sigma][Delta]-modulator for a CMOS imager", ELECTRONICS, CIRCUITS, AND SYSTEMS, 2009. ICECS 2009. 16TH IEEE INTERNATIONAL CONFERENCE ON, IEEE, PISCATAWAY, NJ, USA, 13 décembre 2009 (2009-12-13), pages 33-36, XP031626346, ISBN: 978-1-4244-5090-9

## Description

### Domaine

La présente demande concerne le domaine des circuits électroniques de façon générale, et vise plus particulièrement le domaine des capteurs d'images CMOS.

### Exposé de l'art antérieur

De façon classique, un capteur d'images CMOS comprend une pluralité de cellules élémentaires ou pixels identiques ou similaires agencés en matrice selon des lignes et des colonnes. Chaque pixel comprend un photodétecteur, par exemple une photodiode polarisée en inverse dont la capacité de jonction est déchargée par un photocourant en fonction d'une intensité lumineuse reçue. Chaque pixel comprend en outre un circuit de lecture adapté à fournir un signal de sortie représentatif de l'intensité lumineuse reçue par le photodétecteur. Traditionnellement, chaque pixel fournit, via son circuit de lecture, un signal de sortie analogique, par exemple une tension ou un courant. Ce signal est ensuite numérisé à l'extérieur du pixel par un circuit de conversion analogique-numérique. Le circuit de conversion analogique-numérique peut être commun à plusieurs pixels du capteur. Par exemple, dans le cas où les pixels sont lus ligne par ligne, c'est-à-dire dans le cas où tous les pixels d'une même ligne sont lus simultanément et où les pixels de lignes distinctes sont lus séquentiellement, le capteur peut comprendre un circuit de conversion analogique-numérique par colonne de pixels.

On a déjà proposé des architectures de capteurs d'images CMOS dans lesquelles chaque pixel comprend tout ou partie d'un convertisseur analogique-numérique de type sigma-delta. Des exemples de telles architectures sont décrites dans les articles "Pixel-level A/D conversion: comparison of two charge packets counting techniques", de A. Peizerat et al., ci-après appelé article A, et "Low-Power, High Dynamic Range CMOS Image Sensor Employing Pixel-level Oversampling ΣΔ Analog-to-Digital Conversion", ci-après appelé article B, dont les contenus respectifs sont considérés comme faisant partie intégrante de la présente description.

Rappelons d'abord la structure générale d'un convertisseur analogique-numérique de type sigma-delta. Un tel convertisseur comprend typiquement un modulateur sigma-delta recevant un signal analogique d'entrée à numériser et fournissant, à une fréquence relativement élevée, une suite d'échantillons numériques intermédiaires à basse résolution (typiquement des échantillons binaires) représentatifs du signal d'entrée. La sortie du modulateur sigma-delta est reliée à un circuit de filtrage numérique et de décimation, qui reçoit les échantillons numériques intermédiaires fournis par le modulateur, et fournit des échantillons numériques haute-résolution (supérieure à la résolution des échantillons de sortie du modulateur) représentatifs du signal analogique d'entrée, à une fréquence inférieure à la fréquence de fourniture des échantillons intermédiaires par le modulateur sigma-delta. Le nombre d'échantillons basse-résolution utilisés pour produire une valeur numérique de sortie haute-résolution est généralement désigné par l'acronyme OSR, de l'anglais "Over Sampling Ratio" (taux de sur-échantillonnage).

De façon classique, un modulateur sigma-delta d'ordre 1 comprend un intégrateur analogique, typiquement une capacité, et, en sortie de l'intégrateur, un convertisseur analogique-numérique basse-résolution, typiquement un comparateur 1-bit. Le signal analogique d'entrée du modulateur (le signal à numériser) est appliqué en entrée de l'intégrateur, la sortie du convertisseur analogique-numérique basse-résolution formant la sortie du modulateur sigma-delta. La sortie du convertisseur analogique-numérique basse résolution est en outre reliée à l'entrée de l'intégrateur par l'intermédiaire d'une boucle de rétroaction comportant un convertisseur numérique-analogique basse-résolution. Plus particulièrement, le signal analogique fourni par la boucle de rétroaction est soustrait au signal analogique d'entrée au niveau de l'intégrateur, de façon que l'intégrateur intègre un signal représentatif de l'erreur de quantification du convertisseur analogique-numérique basse-résolution.

Les convertisseurs analogique-numérique de type sigma-delta peuvent être utilisés pour diverses raisons, et notamment parce qu'ils présentent un encombrement et une consommation électrique relativement faibles, et sont robustes aux non-idéalités des composants. De plus, dans le domaine des capteurs d'images, les convertisseurs sigma-delta permettent d'étendre la plage dynamique des pixels.

Dans l'article A susmentionné, chaque pixel comprend un modulateur sigma-delta d'ordre 1 asynchrone, dont l'intégrateur est constitué par une capacité déchargée par un photocourant produit par la photodiode du pixel. Le convertisseur analogique-numérique basse-résolution est constitué par un comparateur comparant la tension aux bornes de la capacité d'intégration à une tension de référence, et fournissant un signal de sortie binaire représentatif du résultat de cette comparaison. La sortie du comparateur constitue la sortie numérique du modulateur. La sortie du comparateur pilote de plus un circuit d'injection de charges qui forme la boucle de rétroaction du modulateur. Plus particulièrement, chaque fois que la tension aux bornes de la capacité d'intégration passe sous la tension de référence, la sortie du comparateur commande l'injection de charges positives dans la capacité d'intégration, de façon à recharger cette capacité à une tension supérieure à la tension de référence. Deux types de circuits de rétroaction sont proposés dans l'article A, à savoir un circuit réalisant une rétroaction en tension (la capacité d'intégration est réinitialisée à un niveau de tension prédéterminé), et un circuit réalisant une rétroaction en charges (une quantité de charges prédéterminée est injectée dans la capacité d'intégration). La sortie du comparateur est reliée à un compteur asynchrone externe au modulateur sigma-delta (circuit de filtrage numérique), qui compte le nombre de fois que la tension de la capacité d'intégration passe sous la tension de référence pendant une période d'intégration du pixel.

Dans une architecture du type décrit dans l'article A, du fait de la nature asynchrone du modulateur sigma-delta, il est en pratique nécessaire que chaque pixel comporte son propre circuit de filtrage numérique, ce qui pose problème du fait de l'encombrement relativement important des compteurs numériques.

Dans l'article B susmentionné, chaque pixel comprend une partie seulement d'un modulateur sigma-delta d'ordre 1, l'autre partie du modulateur étant commune à plusieurs pixels du capteur. Plus particulièrement, dans l'article B, chaque pixel comprend un intégrateur, formé par la capacité de jonction de la photodiode du pixel, et un circuit de rétroaction pour réinitialiser en charges la photodiode du pixel, c'est-à-dire pour injecter une quantité de charges prédéterminée dans la photodiode. Le convertisseur analogique-numérique basse-résolution, un comparateur 1-bit, est externe au pixel, et est partagé par plusieurs pixels du capteur. Plus particulièrement, dans l'article B, les pixels sont sélectionnables en lecture ligne par ligne, et le capteur comprend un comparateur de courant 1-bit par colonne de pixels. Dans chaque pixel, la sortie analogique de l'intégrateur est reliée à l'entrée du comparateur par l'intermédiaire d'un transistor monté en source de courant (la grille de ce transistor étant connectée à la sortie en tension de l'intégrateur), d'un transistor de sélection, et d'une piste conductrice de sortie du pixel, commune à tous les pixels de la colonne. De plus, dans chaque pixel, un noeud de commande du circuit de rétroaction est relié à la sortie numérique (binaire) du comparateur par l'intermédiaire d'une piste conductrice commune à tous les pixels de la colonne. Le circuit d'injection de charges forme le convertisseur numérique-analogique basse-résolution de la boucle de rétroaction du modulateur sigma-delta. Le capteur comprend en outre un circuit de filtrage par colonne de pixels, en aval du comparateur 1-bit de la colonne.

Dans l'article B, les modulateurs sigma-delta ont un fonctionnement synchrone, c'est-à-dire que le convertisseur analogique-numérique basse-résolution est piloté par un signal d'horloge, la sortie binaire du convertisseur basse-résolution étant apte à changer d'état uniquement sur une impulsion ou un front du signal d'horloge.

Un inconvénient de l'architecture décrite dans l'article B est que les signaux de sortie des pixels sont des signaux analogiques (courants), et sont donc relativement peu robustes aux perturbations parasites.

Par ailleurs, un autre inconvénient de l'architecture décrite dans l'article B est que la cadence de lecture des données de sortie des pixels est relativement élevée. A titre d'exemple illustratif, pour produire des échantillons numériques de sortie sur 10-bits avec un rapport signal sur bruit satisfaisant, il convient de prévoir un OSR de l'ordre de 2¹⁰ = 1024 (c'est-à-dire 1024 lectures par pixel). Dans le cas d'un capteur de 500 lignes dans lequel les pixels sont lus ligne par ligne, et pour une fréquence d'acquisition de 50 images par seconde, la fréquence de balayage des lignes est alors de l'ordre de f = 50 * 500 * 2¹⁰ = 25,6 MHz. Une telle fréquence de lecture entraine une consommation électrique relativement élevée, et peut conduire à des erreurs de lecture, notamment dans le cas d'une architecture du type décrit dans l'article B, dans laquelle les signaux de sortie des pixels sont des signaux

L'article "Sigma-delta A/D converter for CMOS image sensors",Silva P M et al., divulgue un capteur d'images CMOS comportant une pluralité de pixels comprenant chacun une photodiode, un modulateur sigma-delta d'ordre 1, adapté à fournir un signal numérique binaire représentatif du niveau d'éclairement de la photodiode.

L'article "A low-power continuous-time incremental 2nd-order-MASH Sigma-Delta-modulator for a CMOS imager", Johannes Uhlig et al., divulgue un capteur d'images CMOS utilisant un convertisseur sigma-delta d'ordre 2 pour chaque colonne, dans une architecture MASH modifiée, dans laquelle un premier étage effectue une conversion grossière, suivi par un étage de conversion fine.

Il serait souhaitable de pouvoir disposer d'un capteur d'images CMOS à conversion analogique-numérique sigma-delta, ce capteur palliant tout ou partie des inconvénients des capteurs existants.

### Résumé

Ainsi, un mode de réalisation prévoit un capteur d'images CMOS comportant une pluralité de pixels comprenant chacun : une photodiode ; un modulateur sigma-delta d'ordre p, avec p entier supérieur ou égal à 1, adapté à fournir un signal numérique binaire représentatif du niveau d'éclairement de la photodiode ; et un circuit configurable de liaison permettant de relier le modulateur sigma-delta du pixel à un modulateur sigma-delta d'un autre pixel, de façon que les modulateurs des deux pixels forment ensemble un modulateur sigma-delta d'ordre supérieur à p.

Selon un mode de réalisation, les pixels sont répartis par groupes de q pixels, avec q entier supérieur ou égal à 2, les pixels d'un même groupe étant interconnectés et les circuits de liaison des pixels d'un même groupe pouvant être configurés pour relier les modulateurs d'ordre p des pixels du groupe de façon que ces modulateurs forment ensemble un modulateur sigma-delta d'ordre q*p.

Selon un mode de réalisation, dans chaque pixel, le modulateur sigma-delta d'ordre p du pixel comprend un intégrateur analogique comportant la photodiode du pixel.

Selon un mode de réalisation, dans chaque pixel, le modulateur sigma-delta d'ordre p comprend un convertisseur analogique-numérique d'un signal analogique de sortie de l'intégrateur analogique du pixel.

Selon un mode de réalisation, dans chaque pixel, le convertisseur analogique-numérique comprend un comparateur comparant ledit signal de sortie à un signal de référence.

Selon un mode de réalisation, dans chaque pixel, le modulateur sigma-delta d'ordre p comprend un circuit de rétroaction reliant un noeud de sortie du convertisseur analogique-numérique à un noeud de l'intégrateur analogique du pixel.

Selon un mode de réalisation, dans chaque pixel, le circuit de rétroaction est adapté à injecter une quantité de charges prédéterminée dans l'intégrateur analogique du pixel.

Selon un mode de réalisation, les charges sont de signe opposé à celui des charges photogénérées accumulées dans la photodiode du pixel.

Selon un mode de réalisation, dans chaque pixel, le circuit de rétroaction comprend des premier, deuxième et troisième transistors MOS à canal P en série entre le noeud de l'intégrateur analogique du pixel, et un noeud d'application d'un premier signal de commande.

Selon un mode de réalisation, dans chaque pixel, les grilles de commande des deuxième et troisième transistors MOS à canal P sont reliées respectivement à des premier et deuxième potentiels de polarisation.

Selon un mode de réalisation, dans chaque pixel, la grille de commande du premier transistor MOS à canal P est reliée à un noeud d'application d'un deuxième signal de commande et audit noeud de sortie du convertisseur analogique-numérique par l'intermédiaire d'une porte logique.

Selon un mode de réalisation, dans chaque pixel, le circuit de liaison est adapté à injecter, sur un noeud de l'intégrateur analogique du pixel, une quantité de charges représentative d'un signal de sortie de l'intégrateur analogique d'un autre pixel du capteur.

Selon un mode de réalisation, dans chaque pixel, le circuit de liaison comprend des premier, deuxième et troisième transistors MOS à canal N en série entre le noeud de sortie de l'intégrateur analogique du pixel et un noeud d'application d'un troisième signal de commande.

Selon un mode de réalisation, dans chaque pixel, les grilles de commande des deuxième et troisième transistors MOS à canal N sont reliées respectivement à un troisième potentiel de polarisation et à un noeud d'un intégrateur analogique d'un autre pixel du capteur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique partiel d'un exemple d'un capteur d'images CMOS ;
la figure 2 est un chronogramme représentant l'évolution d'une tension analogique aux bornes d'une photodiode d'un pixel du capteur de la figure 1 ;
les figures 3A et 3B sont des chronogrammes illustrant un exemple de procédé de commande du capteur de la figure 1 ;
la figure 4 est un schéma électrique partiel d'un exemple d'un mode de réalisation d'un capteur d'images CMOS ; et
la figure 5 est un chronogramme illustrant un exemple de procédé de commande du capteur de la figure 4.

### Description détaillée

Par souci de clarté, de mêmes éléments ont été désignés par de mêmes références aux différentes figures et, de plus, les divers chronogrammes ne sont pas tracés à l'échelle. On notera par ailleurs que dans la présente description, lorsque des architectures de pixels ou de capteurs d'images sont décrites, on utilise le terme "connecté" pour désigner une liaison électrique directe, sans composant électronique intermédiaire, par exemple au moyen d'une piste conductrice, et le terme "couplé" ou le terme "relié", pour désigner une liaison électrique directe ou via un ou plusieurs composants intermédiaires, par exemple via un ou plusieurs transistors MOS.

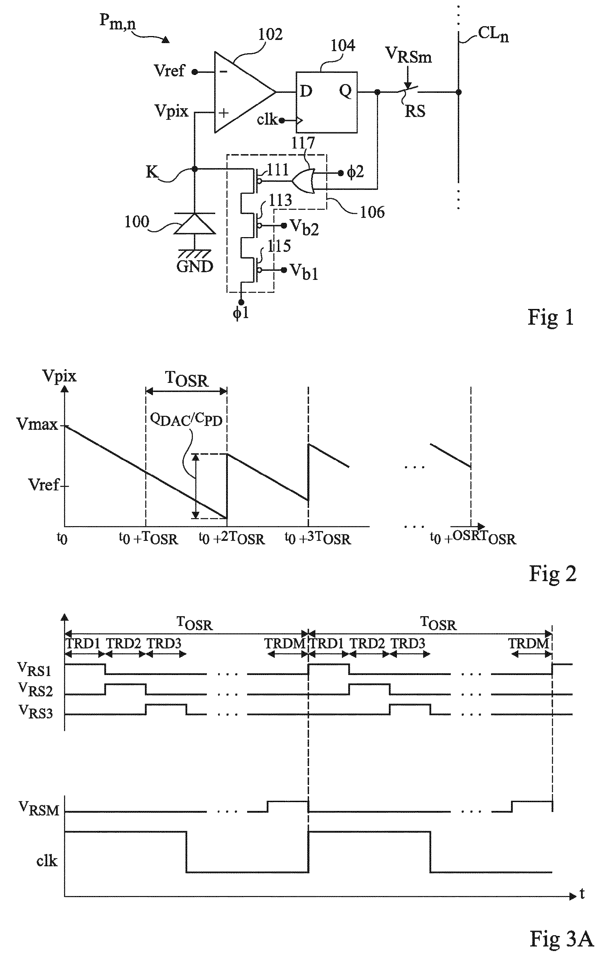

La figure 1 est un schéma électrique partiel d'un exemple d'un capteur d'images CMOS. Le capteur de la figure 1 comprend une pluralité de pixels identiques ou similaires. A titre d'exemple, le capteur de la figure 1 comprend M*N pixels P_{m,n} agencés en matrice selon M lignes et N colonnes, avec M et N entiers supérieurs à 1, m entier allant de 1 à M, et n entier allant de 1 à N. Sur la figure 1, par souci de simplification, seul un pixel P_{m,n} du capteur a été représenté.

Le pixel P_{m,n} comprend une photodiode 100 polarisée en inverse, dont l'anode est connectée à un noeud d'application d'un potentiel de référence GND, par exemple la masse, et dont la cathode est connectée à un noeud K d'accumulation de charges photogénérées. Le pixel P_{m,n} comprend en outre un comparateur 102 à deux entrées analogiques et une sortie binaire. Une entrée (+) du comparateur 102 est connectée au noeud K, et l'autre entrée (-) du comparateur 102 est connectée à un noeud d'application d'une tension de référence V_{ref}. Le comparateur 102 comprend par exemple un amplificateur opérationnel monté en comparateur de tension, dont une entrée inverseuse est reliée au noeud d'application du potentiel de référence V_{ref}, et dont une entrée non inverseuse est reliée au noeud K. La sortie du comparateur est reliée à une entrée de données binaires D d'une bascule 104. Dans l'exemple représenté, la bascule 104 du pixel P_{m,n} comprend en outre une entrée d'application d'un signal d'horloge clk, et une sortie de données binaires Q. Le fonctionnement du circuit 104 est tel que, à chaque front montant ou à chaque front descendant du signal d'horloge clk, la donnée binaire présente sur l'entrée D de la bascule 104 est recopiée sur sa sortie Q. Le pixel P_{m,n} comprend en outre un circuit 106 d'injection de charges positives sur le noeud d'accumulation K de la photodiode 100. Le circuit 106 comprend trois transistors MOS à canal P 111, 113 et 115 connectés en série entre le noeud K et un noeud d'application d'un signal de commande binaire Φ1, par exemple une tension. Plus particulièrement, dans cet exemple, le transistor 111 a un premier noeud de conduction connecté au noeud K et un deuxième noeud de conduction connecté à un premier noeud de conduction du transistor 113, le transistor 113 a un deuxième noeud de conduction connecté à un premier noeud de conduction du transistor 115, et le transistor 115 a un deuxième noeud de conduction connecté au noeud d'application de la tension Φ1. Le transistor 115 a sa grille de commande reliée à un noeud d'application d'une tension de polarisation fixe V_{b1}, et le transistor 113 a sa grille de commande reliée à un noeud d'application d'une tension de polarisation fixe V_{b2}. Le circuit 106 comprend en outre une porte logique OU 117 à deux entrées et une sortie, dont la sortie est reliée à la grille de commande du transistor 111, et dont les entrées sont reliées respectivement à la sortie Q de la bascule 104 et à un noeud d'application d'un signal binaire de commande Φ2, par exemple une tension.

Ainsi, dans l'exemple de la figure 1, chaque pixel P_{m,n} du capteur comprend un modulateur sigma-delta d'ordre 1 synchrone, dont l'intégrateur est formé par la capacité de la photodiode 100 du pixel. Le comparateur 102 et la bascule 104 forment le circuit de conversion analogique-numérique basse-résolution (1-bit) du modulateur. Le circuit 106 ou circuit de rétroaction forme la boucle de rétroaction du modulateur.

Le pixel P_{m,n} comprend en outre un interrupteur de sélection RS, par exemple un transistor MOS, reliant la sortie Q de la bascule 104, c'est-à-dire la sortie du modulateur sigma-delta, à une piste conductrice de sortie CLₙ commune à tous les pixels de la colonne de rang n du capteur.

Dans cet exemple, les pixels du capteur de la figure 1 sont activables en lecture ligne par ligne, c'est-à-dire notamment que tous les interrupteurs de sélection RS des pixels P_{m,n} d'une même ligne ont leurs noeuds de commande reliés à un même noeud d'application d'un signal de commande V_{RSm}, les noeuds de commande des interrupteurs de sélection RS de pixels de lignes distinctes étant reliés à des noeuds d'application de signaux de commande distincts.

Dans l'exemple de la figure 1, le capteur peut comporter un circuit de filtrage numérique (non représenté), par exemple un compteur numérique, par colonne de pixels du capteur. A titre d'exemple, dans chaque colonne de pixels du capteur, la piste conductrice de sortie CLₙ de la colonne est reliée à une entrée du circuit de filtrage numérique de la colonne.

La figure 2 est un chronogramme représentant l'évolution de la tension analogique Vₚᵢₓ sur le noeud d'accumulation K d'un pixel P_{m,n} du capteur de la figure 1, lors d'une phase d'acquisition d'une valeur numérique haute-résolution représentative du niveau d'éclairement du pixel (ou valeur de sortie du pixel). Dans cet exemple, l'éclairement du pixel est supposé constant pendant toute la durée de la phase d'acquisition.

On désigne ci-après par T_{OSR} la période de sur-échantillonnage du convertisseur sigma-delta, c'est-à-dire la période entre deux lectures binaires successives d'un même pixel du capteur. A titre d'exemple illustratif, dans le cas susmentionné d'un capteur ayant une cadence d'acquisition de 50 images par seconde, et pour une conversion sigma-delta effectuée avec un OSR égal à 1024, la période T_{OSR} est approximativement égale à 1/50/1024 ≈ 19,5 μs. Dans cet exemple, la période du signal d'horloge clk est égale à T_{OSR}.

A un instant t0 de début de la phase d'acquisition, la photodiode a été réinitialisée, par exemple par l'intermédiaire du circuit d'injection de charges 106 ou par l'intermédiaire d'un circuit spécifique de réinitialisation du pixel (non représenté), et la tension Vₚᵢₓ est à une valeur positive haute Vₘₐₓ. La tension Vₚᵢₓ décroit ensuite à une vitesse représentative de l'intensité lumineuse reçue par le pixel.

Après l'instant t0, à chaque période du signal d'horloge clk, par exemple à chaque front montant ou à chaque front descendant du signal clk, la valeur de sortie binaire du comparateur 102 est mémorisée dans la bascule 104. Cette valeur est à un premier état, correspondant par exemple à la valeur binaire '0', si, lors du front d'horloge, la tension Vₚᵢₓ est inférieure à la tension de référence V_{ref}, et est à un deuxième état, correspondant par exemple à la valeur binaire '1', si, lors du front d'horloge, la tension Vₚᵢₓ est supérieure à la tension V_{ref}.

Avant la période d'horloge suivante, la valeur de sortie de la bascule 104 est lue via la piste conductrice de sortie CLₙ du pixel. De plus, avant la période d'horloge suivante, si la valeur de sortie de la bascule 104 indique que la tension Vₚᵢₓ est inférieure à la tension V_{ref}, le circuit de rétroaction 106 est commandé pour injecter sur le noeud K une quantité de charges positives prédéterminée Q_{DAC}. Dans ce cas, la tension Vₚᵢₓ est incrémentée d'une valeur égale à Q_{DAC}/C_{PD}, où C_{PD} désigne la capacité du noeud K, ou capacité de la photodiode 100. Si en revanche la valeur de sortie de la bascule 104 indique que la tension Vₚᵢₓ est supérieure à la tension de référence V_{ref}, le circuit de rétroaction 106 n'injecte pas de charges dans la photodiode.

Les étapes susmentionnées de mémorisation et lecture de la valeur binaire de sortie du comparateur 102, et, selon la valeur mémorisée, d'injection ou non d'un paquet de charges Q_{DAC} dans la photodiode 100, sont répétées périodiquement OSR fois, à la fréquence du signal d'horloge clk (égale à 1/T_{OSR}).

Les OSR valeurs numériques binaires lues pendant la phase d'acquisition sont intégrées dans le circuit de filtrage numérique couplé au pixel P_{m,n}, de façon à produire une valeur de sortie numérique haute-résolution du pixel.

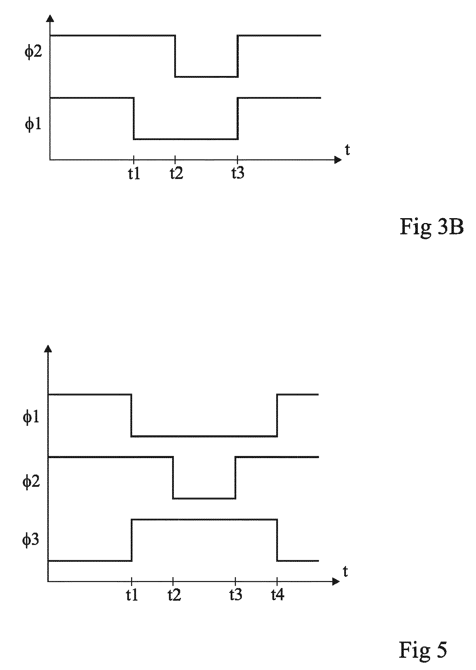

Les figures 3A et 3B sont des chronogrammes illustrant plus en détail un exemple de procédé de commande du capteur de la figure 1.

Dans cet exemple, les pixels du capteur sont lus ligne par ligne à basse-résolution (1-bit), l'ensemble des lignes étant balayé OSR fois de façon à fournir OSR images de 1-bit par pixel. Une image finale haute-résolution est reconstruite par les circuits de filtrage numérique, à partir des OSR images binaires. Dans cet exemple, les phases d'intégration de tous les pixels du capteur débutent simultanément, et les étapes de quantification basse-résolution du signal intégré (via le convertisseur analogique numérique formé par le comparateur 102 et la bascule 104), de conversion numérique-analogique du signal basse-résolution (via le circuit 106), et de soustraction du signal de rétroaction au signal intégré (via le circuit 106), sont réalisées simultanément pour tous les pixels du capteur.

A chaque période T_{OSR}, toutes les lignes du capteur sont lues successivement selon un mode de lecture par balayage généralement désigné dans la technique par les termes anglo-saxons "rolling shutter" (ou lecture à obturation déroulante).

Ceci est illustré par la figure 3A qui représente l'évolution, en fonction du temps, du signal d'horloge clk (commun à tous les pixels du capteur), et des signaux de commandes V_{RS1}, V_{RS2}, V_{RS3}, ..., V_{RSM}, respectivement appliqués sur les noeuds de commande des interrupteurs de sélection RS des pixels des M lignes du capteur.

Comme cela apparaît sur la figure 3A, chaque période du signal d'horloge clk, de durée T_{OSR}, qui correspond à une phase d'acquisition d'une image binaire (par exemple entre deux fronts montants successifs du signal d'horloge clk), est divisée en M périodes successives T_{RD1}, T_{RD2}, T_{RD3}, ... , T_{RDM}, par exemple égales à T_{OSR}/M. A chaque période T_{RDm}, l'une des lignes de pixels du capteur est activée en lecture, par la fermeture des interrupteurs de sélection RS des pixels de la ligne (signal V_{RSm} de la ligne à l'état haut dans cet exemple), les interrupteurs de sélection RS des pixels des autres lignes du capteur étant maintenus ouverts. Les valeurs binaires de sortie des N pixels de la ligne sont lues simultanément, via les pistes conductrices CLₙ, par les circuits de filtrage couplés aux pistes CLₙ.

Par ailleurs, à chaque période T_{OSR}, par exemple pendant la période T_{RD1} de lecture de la première ligne de pixels du capteur, une phase de conversion numérique-analogique du signal de sortie de la bascule 104, et de réinjection du signal analogique résultant dans l'intégrateur formé par la photodiode, est mise en oeuvre simultanément dans tous les pixels du capteur, via les circuits 106 respectifs des pixels. Cette phase, que l'on appellera ci-après phase de rétroaction, est détaillée en figure 3B.

La figure 3B illustre plus particulièrement l'évolution, en fonction du temps, des signaux de commande φ1 et φ2 (communs à tous les pixels du capteur) des circuits 106 des pixels du capteur.

Dans l'exemple représenté, lors d'une phase de pré-charge préalable à la phase de rétroaction proprement dite, le signal φ2 est d'abord mis à l'état haut, d'où il résulte que le transistor 111 est non passant. Pendant la phase de pré-charge, le signal φ1 est aussi mis à l'état haut, ce qui entraine l'accumulation de charges positives sous la grille du transistor PMOS 113.

A un instant t1 de début de la phase de rétroaction, le signal φ1 est mis à l'état bas, le signal φ2 étant maintenu à l'état haut, d'où il résulte qu'une quantité de charges positives Q_{DAC} ≈ Cₒₓ₁₁₃*W₁₁₃*L₁₁₃*(V_{b1}-V_{b2}), isolée du noeud d'application du signal φ1, reste piégée sous la grille du transistor 113, où Cₒₓ₁₁₃, W₁₁₃ et L₁₁₃ désignent respectivement la capacité surfacique définie par l'oxyde de grille du transistor 113, la largeur de grille du transistor 113, et la longueur de grille du transistor 113.

A un instant t2 postérieur à l'instant t1, le signal φ2 est mis à l'état bas, le signal φ1 étant maintenu à l'état bas. Il en résulte que, si la sortie de la bascule 104 est à l'état bas (Vₚᵢₓ < V_{ref}), le transistor 111 est rendu passant, ce qui provoque le transfert, sur le noeud K, du paquet de charges Q_{DAC} stocké sous la grille du transistor 113. Si en revanche la sortie de la bascule 104 est à l'état haut (Vₚᵢₓ > V_{ref}), le transistor 111 reste non passant, et aucune charge n'est injectée dans la photodiode par le circuit 106.

A un instant t3 postérieur à l'instant t2, marquant la fin de la phase de rétroaction, les signaux φ1 et φ2 sont remis à l'état haut, de façon à recharger le circuit de rétroaction 106 en vue de la prochaine phase de rétroaction.

Un avantage du capteur décrit en relation avec les figures 1, 2, 3A et 3B est que, du fait de la nature synchrone de la lecture de type "rolling shutter", les circuits de filtrage numérique des convertisseurs analogiques numérique peuvent être déportés à l'extérieur des pixels, et partagés par plusieurs pixels du capteur. De plus, les signaux de sortie des pixels sont des signaux numériques, et sont donc relativement robustes aux perturbations parasites et aux non-idéalités technologiques.

A titre de variante, on peut prévoir une architecture asynchrone dans laquelle la sortie du comparateur 102 est reliée au transistor 111 par un circuit intermédiaire permettant de générer une impulsion de tension lorsque la tension Vₚᵢₓ du noeud K passe sous la tension de référence V_{ref}. Dans ce cas, la bascule 104 n'est plus sur le chemin de contre-réaction du modulateur, et peut être une bascule asynchrone. Cette bascule permet de stocker l'évènement, s'il a eu lieu lors d'une période T_{OSR}, pour être lue de manière synchrone lors d'une lecture de type "rolling shutter" (la bascule étant alors réinitialisée à la fin de chaque période T_{OSR}). Un exemple de ce circuit intermédiaire pour une réinitialisation asynchrone en charge est présenté dans l'article A susmentionné.

Un problème qui peut se poser dans l'architecture décrite en relation avec les figures 1, 2, 3A et 3B, est que la fréquence de balayage de la matrice de pixels lors de la lecture des données de sortie binaires des pixels, de l'ordre de M/T_{OSR}, est relativement élevée, ce qui entraine une consommation électrique relativement importante, et peut, dans certains cas, conduire à des erreurs de lecture.

Pour diminuer la fréquence de lecture des pixels, il faudrait pouvoir diminuer l'OSR, c'est-à-dire le nombre d'images binaires utilisées pour générer une image finale haute-résolution. Pour pouvoir diminuer l'OSR sans augmenter significativement le bruit contenu dans l'image finale, on peut prévoir, dans chaque pixel du capteur de la figure 1, de remplacer le modulateur sigma-delta d'ordre 1 par un modulateur sigma-delta d'ordre supérieur à 1, par exemple un modulateur sigma-delta d'ordre 2.

Un modulateur sigma-delta d'ordre p, avec p entier supérieur à 1, diffère d'un modulateur sigma-delta d'ordre 1 essentiellement en ce qu'il comprend non pas un seul mais p intégrateurs analogiques, généralement reliés en série en amont du convertisseur analogique-numérique basse-résolution. Le signal de rétroaction du modulateur peut être réinjecté soit en entrée du premier intégrateur seulement, soit en entrée du premier intégrateur et en entrée d'un ou plusieurs des intégrateurs suivants, avec éventuellement des coefficients de pondération différents.

En augmentant l'ordre du modulateur sigma-delta, il est possible, à résolutions de quantification identiques et à niveaux de bruit de quantification identiques, de diminuer de façon significative l'OSR du convertisseur sigma-delta. A titre d'exemple illustratif, dans le cas susmentionné d'une quantification sur 10 bits, le remplacement d'un modulateur d'ordre 1 par un modulateur d'ordre 2 permet de réduire l'OSR d'un facteur environ égal à 10, sans diminuer le rapport signal sur bruit. Ainsi, pour obtenir un rapport signal sur bruit satisfaisant avec un convertisseur sigma-delta d'ordre 2, un OSR environ égal à 100 serait suffisant, ce qui permettrait de diminuer d'un facteur environ égal à 10 la fréquence de balayage du capteur dans une architecture du type décrit en relation avec les figures 1, 2, 3A et 3B.

Toutefois, les modulateurs sigma-delta sont d'autant plus encombrants que leur ordre est élevé, notamment du fait de l'augmentation du nombre d'intégrateurs analogiques qu'ils comportent. L'intégration d'un modulateur sigma-delta d'ordre élevé au sein d'un pixel d'un capteur d'images peut donc poser problème.

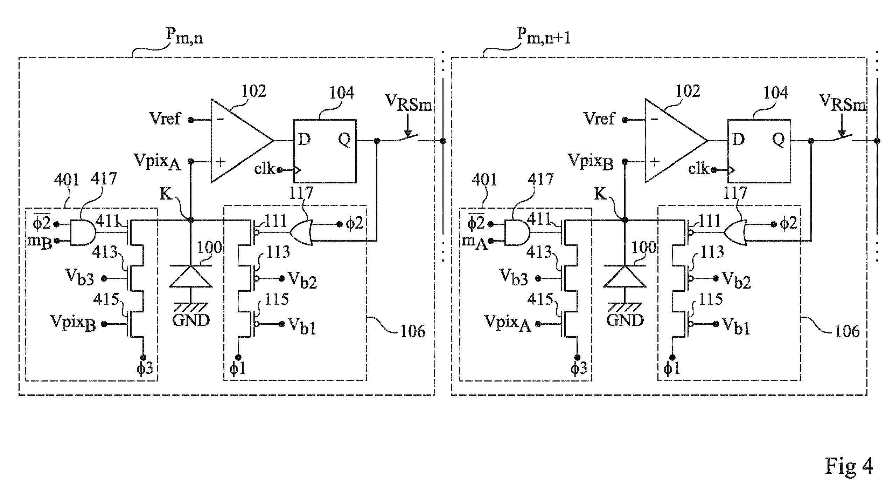

La figure 4 est un schéma électrique partiel d'un exemple d'un mode de réalisation d'un capteur d'images CMOS. Le capteur de la figure 4 comprend une pluralité de pixels identiques ou similaires, par exemple disposés en matrice selon des lignes et des colonnes. Dans le capteur de la figure 4, comme cela sera expliqué plus en détail ci-après, les pixels sont interconnectés deux à deux. Dans cet exemple, on considère un capteur comportant une matrice de MxN pixels P_{m,n}, où M*N est un nombre pair. Ce capteur comporte M*N/2 groupes de deux pixels interconnectés. Les pixels d'un même groupe sont de préférence voisins. En outre, les pixels d'un même groupe sont de préférence agencés de façon à pouvoir être lus simultanément. Dans cet exemple, les pixels sont activables en lecture ligne par ligne, et les pixels d'un même groupe de pixels interconnectés sont des pixels voisins d'une même ligne de pixels (dans cet exemple, le nombre N de colonnes de pixels du capteur est pair). Par souci de simplification, seuls deux pixels P_{m,n} et P_{m,n+1} d'un même groupe de pixels interconnectés, appartenant à une même ligne de rang m du capteur et à des colonnes voisines de rangs n et n+1, ont été représentés sur la figure 4.

Dans cet exemple, chaque pixel du capteur de la figure 4 comprend sensiblement les mêmes éléments qu'un pixel du capteur de la figure 1, à savoir une photodiode 100, un comparateur 102, un circuit de mémorisation synchrone 104, un circuit de rétroaction 106, et un interrupteur de sélection RS, agencés sensiblement de la même manière que dans l'exemple de la figure 1. Ces éléments ne seront pas détaillés à nouveau ci-après.

Chaque pixel du capteur de la figure 4 comprend en outre un circuit configurable de liaison 401, permettant de relier le modulateur sigma-delta d'ordre 1 du pixel au modulateur sigma-delta d'ordre 1 de l'autre pixel du même groupe de pixels interconnectés, de façon à former un modulateur sigma-delta d'ordre 2. Dans cet exemple, le circuit de liaison 401 comprend trois transistors MOS à canal N 411, 413 et 415 connectés en série entre le noeud K du pixel et un noeud d'application d'un signal de commande binaire Φ3, par exemple une tension. Plus particulièrement, dans cet exemple, le transistor 411 a un premier noeud de conduction connecté au noeud K du pixel et un deuxième noeud de conduction connecté à un premier noeud de conduction du transistor 413, le transistor 413 a un deuxième noeud de conduction connecté à un premier noeud de conduction du transistor 415, et le transistor 415 a un deuxième noeud de conduction connecté au noeud d'application de la tension Φ3. Dans chaque pixel, le transistor 415 a sa grille de commande reliée au noeud K de l'autre pixel du même groupe de pixels interconnectés. Le transistor 413 a sa grille de commande reliée à un noeud d'application d'une tension de polarisation fixe V_{b3}. Dans cet exemple, le circuit 401 comprend en outre une porte logique ET 417 à deux entrées et une sortie. La sortie de la porte 417 est reliée à la grille de commande du transistor 411, une première entrée de la porte 417 est reliée à un noeud d'application d'un signal de commande binaire *̅Φ̅*̅2̅ complémentaire du signal Φ2 (la première entrée de la porte 417 est par exemple reliée au noeud d'application du signal de commande Φ2 par l'intermédiaire d'un inverseur non représenté), et la deuxième entrée de la porte 417 est reliée à un noeud d'application d'un signal binaire de configuration, par exemple une tension. Les signaux binaires de configuration des premier et deuxième pixels d'un même groupe de pixels interconnectés sont commandables indépendamment l'un de l'autre, et sont respectivement désignés par les références m_{B} pour un premier pixel du groupe (le pixel P_{m,n} dans l'exemple représenté) et m_{A} pour l'autre pixel du groupe (le pixel P_{m,n+1} dans l'exemple représenté). A titre d'exemple, les signaux logiques de configuration m_{A} et m_{B} sont communs à tous les groupes de pixels interconnectés du capteur. Par ailleurs, dans cet exemple, les tensions de polarisation V_{b1}, V_{b2} et V_{b3} sont communes à tous les pixels du capteur, et les signaux de commande Φ1, Φ2 et Φ3, ainsi que le signal d'horloge clk, sont communs à tous les pixels du capteur.

Lorsque les signaux de configuration m_{A} et m_{B} sont à l'état bas, les transistors 411 des circuits de liaison 401 des pixels P_{m,n} et P_{m,n+1} sont non passants, et les modulateurs sigma-delta d'ordre 1 des pixels P_{m,n} et P_{m,n+1} sont donc isolés l'un de l'autre. En d'autres termes, dans chaque groupe de pixels interconnectés, les modulateurs sigma-delta d'ordre 1 des premier et deuxième pixels du groupe fonctionnent de manière indépendante. Le capteur peut alors fonctionner de façon identique ou similaire à ce qui a été décrit en relation avec les figures 1, 2, 3A et 3B.

Lorsque les signaux de configuration m_{A} et m_{B} sont respectivement à l'état haut et à l'état bas, le transistor 411 du circuit de liaison 401 du pixel P_{m,n} est maintenu bloqué quel que soit l'état du signal de commande Φ2. En revanche, le transistor 411 du circuit de liaison du pixel P_{m,n+1} peut être rendu passant par l'intermédiaire du signal de commande *̅Φ̅*̅2̅. Le circuit de liaison 401 du pixel P_{m,n+1} permet alors d'injecter, dans l'intégrateur du modulateur sigma-delta d'ordre 1 du pixel P_{m,n+1}, c'est-à-dire sur le noeud K du pixel P_{m,n+1}, un signal représentatif de l'erreur de quantification du modulateur d'ordre 1 du pixel P_{m,n}. Les modulateurs sigma-delta d'ordre 1 des pixels P_{m,n} et P_{m,n+1} forment alors ensemble un modulateur sigma-delta d'ordre 2.

Un tel modulateur sigma-delta d'ordre 2, constitué par la mise en série de deux modulateurs d'ordre 1 comprenant chacun un intégrateur analogique, un convertisseur analogique-numérique basse résolution, et une boucle de rétroaction, est généralement appelé modulateur MASH (de l'anglais "Multi Stage Noise Shaping" - modulateur à mise en forme du bruit multi-étage). Le principe de fonctionnement des modulateurs sigma-delta de type MASH est par exemple décrit dans l'article "Sturdy MASH Δ-Σ modulator" de Maghari et al. (ELECTRONICS LETTERS 26th October 2006 Vol.42 No.22), dont le contenu est considéré comme faisant partie intégrante de la présente description. Dans un tel modulateur, un premier modulateur d'ordre 1, ou modulateur amont, reçoit le signal analogique à numériser sur son entrée analogique, et le deuxième modulateur d'ordre 1, ou modulateur aval, reçoit sur son entrée analogique un signal représentatif de l'erreur de quantification du premier modulateur d'ordre 1. Lors d'une phase d'acquisition d'une valeur numérique haute-résolution représentative d'un signal analogique d'entrée, chacun des modulateurs d'ordre 1 fournit un train de OSR bits en sortie de son convertisseur analogique-numérique basse résolution, les deux trains de bits étant recombinés en un seul train de OSR bits par un circuit numérique de recombinaison, puis intégré numériquement par un circuit de filtrage numérique générant, à partir du train de bits recombiné, une valeur numérique haute-résolution représentative du signal analogique d'entrée du modulateur amont. Plus généralement, les topologies de type MASH se déclinent quel que soit l'ordre des modulateurs élémentaires reliés en série, et quel que soit le nombre de modulateurs élémentaires reliés en série. Les modulateurs élémentaires sont alors reliés de façon que chaque modulateur de l'association en série de modulateurs élémentaires, à l'exception du premier modulateur élémentaire, reçoive sur son entrée analogique, un signal représentatif de l'erreur de quantification du modulateur précédent. Un avantage des modulateurs sigma-delta de type MASH est qu'ils permettent d'obtenir des ordres de modulation élevés, en s'affranchissant des problèmes usuellement rencontrés (notamment des problèmes d'instabilité) dans la réalisation de modulateurs sigma-delta traditionnels d'ordre élevés (comportant plusieurs intégrateurs analogiques en série mais un seul convertisseur analogique-numérique et une seule boucle de rétroaction).

Dans l'exemple de la figure 4, lorsque les signaux de configuration m_{A} et m_{B} sont respectivement à l'état haut et à l'état bas, le modulateur d'ordre 1 du pixel P_{m,n} est le modulateur amont de la structure MASH. Lors d'une phase d'acquisition d'une valeur de sortie numérique haute-résolution du groupe comprenant les pixels P_{m,n} et P_{m,n+1}, chacun des modulateurs d'ordre 1 des pixels P_{m,n} et P_{m,n+1} fournit un train de bits via la piste de sortie CLₙ, respectivement CLₙ₊₁, du pixel. Les deux trains de bits peuvent être recombinés en un seul train de bits via un circuit de recombinaison, non représenté, par exemple disposé en pied de colonne. Le train de bits recombiné est alors fourni à un circuit de filtrage numérique adapté à produire une valeur de sortie numérique haute-résolution représentative des niveaux d'éclairement reçus par les pixels P_{m,n} et P_{m,n+1}, pondérés par des coefficients différents. Plus particulièrement, on obtient, pour le groupe comportant les pixels P_{m,n} et P_{m,n+1}, une valeur numérique de sortie haute résolution représentative du signal αI(P_{m,n})+βI(P_{m,n+1}), où I(P_{m,n}) et I(P_{m,n+1}) désignent respectivement l'intensité lumineuse reçue par le pixel P_{m,n} et l'intensité lumineuse reçue par le pixel P_{m,n+1}, et où α et β sont des coefficients de pondération distincts, avec α>β (le niveau d'éclairement reçu par le pixel amont du groupe est en effet prépondérant par rapport au niveau d'éclairement reçu par le pixel aval du groupe dans la valeur de sortie du convertisseur sigma-delta d'ordre 2). Dans la présente description, les circuits de recombinaison et les circuits de filtrage numérique n'ont pas été décrits, les modes de réalisation décrits étant compatibles avec les circuits usuels de recombinaison et de filtrage numérique, utilisés dans les convertisseurs sigma-delta existants.

Lorsque les signaux de configuration m_{A} et m_{B} sont respectivement à l'état bas et à l'état haut, le fonctionnement est similaire à ce qui vient d'être décrit, à la différence près que le modulateur sigma-delta d'ordre 1 du pixel P_{m,n+1} est en amont du modulateur sigma-delta d'ordre 1 du pixel P_{m,n} dans la structure MASH. La valeur de sortie numérique haute-résolution du convertisseur sigma-delta est alors représentative du signal αI(P_{m,n+1})+βI(P_{m,n}).

Ainsi, pour acquérir une image complète via le capteur de la figure 4, on peut prévoir une première phase d'acquisition d'une image numérique partielle de taille M*N/2, au cours de laquelle les signaux de configuration m_{A} et m_{B} sont respectivement à l'état haut et à l'état bas. Lors de cette première phase d'acquisition, pour chaque groupe de deux pixels interconnectés P1 et P2 du capteur, une valeur de sortie numérique haute résolution représentative du signal αI(P1)+βI(P2) est acquise. Une deuxième phase d'acquisition d'une image numérique partielle de taille M*N/2 peut ensuite être mise en oeuvre, au cours de laquelle les signaux de configuration m_{A} et m_{B} sont respectivement à l'état bas et à l'état haut (c'est-à-dire que, dans chaque groupe de pixels, le pixel amont et le pixel aval sont intervertis). Lors de cette deuxième phase d'acquisition, pour chaque groupe de pixels interconnectés du capteur, une valeur de sortie numérique haute résolution représentative du signal αI(P2)+βI(P1) est acquise. On obtient alors, pour chaque groupe de pixels interconnectés, un système de deux équations à deux inconnues, permettant de déterminer une valeur numérique haute résolution représentative du niveau d'éclairement I(P1) du premier pixel du groupe, et une valeur numérique haute résolution représentative du niveau d'éclairement I(P2) du deuxième pixel du groupe. Ainsi, les deux images partielles acquises peuvent être combinées pour former une image numérique complète, de taille M*N.

Dans l'exemple de la figure 4, lorsque le capteur est configuré pour réaliser une conversion analogique-numérique sigma-delta d'ordre 2, chacune des première et deuxième phases d'acquisition d'une image partielle de taille M*N/2 comprend OSR balayages successifs des M lignes du capteur. Ainsi, l'acquisition d'une image complète comprend 2*OSR balayages successifs des M lignes du capteur. Toutefois, comme indiqué ci-dessus, le passage d'un modulateur sigma-delta d'ordre 1 à un modulateur sigma-delta d'ordre 2 permet de réduire l'OSR d'un facteur significatif, par exemple d'un facteur 10, sans diminuer le rapport signal sur bruit en sortie du convertisseur analogique-numérique. Ainsi, dans le capteur de la figure 4, pour une durée d'acquisition d'image donnée, la fréquence de balayage des lignes du capteur peut être réduite d'un facteur 5 par rapport à un capteur présentant le même nombre de lignes mais réalisant une conversion analogique-numérique sigma-delta d'ordre 1, par exemple un capteur du type décrit en relation avec la figure 1. Ces ordres de grandeur sont bien entendu illustratifs et nullement limitatifs.

A titre de variante, dans certaines applications pour lesquelles la pleine résolution du capteur n'est pas indispensable, on peut prévoir une seule phase d'acquisition d'une image partielle de taille M*N/2, au cours de laquelle le capteur est configuré pour réaliser une conversion analogique-numérique sigma-delta d'ordre 2 (m_{A} et m_{B} étant respectivement à l'état haut et à l'état bas, ou à l'état bas et à l'état haut). Dans ce cas, chaque point de l'image de taille M*N/2 a une valeur représentative à la fois de l'éclairement du premier pixel du groupe de pixels interconnectés correspondant, et de l'éclairement du deuxième pixel du groupe de pixels interconnectés correspondant. Ceci permet par exemple d'augmenter d'un facteur 2 la cadence d'acquisition des images.

Un exemple de procédé de commande du capteur de la figure 4 va maintenant être détaillé. Plus particulièrement, l'exemple de procédé de commande détaillé ci-après correspond à une première phase d'acquisition d'une image partielle de taille M*N/2, le capteur étant configuré pour réaliser une conversion analogique-numérique sigma-delta d'ordre 2. A titre d'exemple, on considère le cas où les signaux de configuration m_{A} et m_{B} sont respectivement à l'état haut et à l'état bas. Un procédé de commande identique ou similaire pourra toutefois être mis en oeuvre lors de la phase d'acquisition de la deuxième partie de l'image (les signaux de configuration m_{A} et m_{B} étant alors respectivement à l'état bas et à l'état haut).

Lors de la phase d'acquisition de la première partie d'image, les pixels du capteur sont lus ligne par ligne à basse-résolution (1-bit), l'ensemble des lignes étant balayé OSR fois de façon à fournir, pour chaque groupe de pixels interconnectés du capteur, deux trains de OSR bits. Dans chaque groupe de pixels, les deux trains de OSR bits sont recombinés par un circuit de recombinaison non représenté, en un seul train de OSR bits représentatif à la fois du photocourant généré dans la photodiode du pixel amont du groupe (le pixel P_{m,n} dans l'exemple représenté) et du photocourant généré dans la photodiode du pixel aval du groupe (le pixel P_{m,n+1} dans cet exemple). Une valeur de sortie numérique haute résolution du groupe comportant les pixels P_{m,n} et P_{m,n+1} est produite, à partir de ce train de bits recombiné, par les circuits de filtrage numérique (non représentés).

Dans cet exemple, les phases d'intégration de tous les pixels du capteur débutent simultanément, et les phases de quantification basse-résolution des signaux analogiques, ainsi que les phases de rétroaction (incluant le transfert de l'erreur de quantification du modulateur d'ordre 1 amont dans l'intégrateur analogique du modulateur d'ordre 1 aval), sont réalisées simultanément dans tous les groupes de pixels du capteur.

A chaque période T_{OSR}, toutes les lignes du capteur sont lues successivement selon un mode de lecture par balayage généralement désigné dans la technique par les termes anglo-saxons "rolling shutter" (ou lecture à obturation déroulante), de façon identique ou similaire à ce qui a été décrit en relation avec la figure 3A.

Comme dans l'exemple de la figure 3A, chaque période du signal d'horloge clk, de durée T_{OSR} (par exemple entre deux fronts montants successifs du signal d'horloge clk), est divisée en M périodes successives T_{RD1}, T_{RD2}, T_{RD3}, ... , T_{RDM}, par exemple égales à T_{OSR}/M. A chaque période T_{RDM}, l'une des lignes de pixels du capteur est activée en lecture, par la fermeture des interrupteurs de sélection RS des pixels de la ligne (signal V_{RSm} de la ligne à l'état haut dans cet exemple), les interrupteurs de sélection RS des pixels des autres lignes du capteur étant maintenus ouverts. Les valeurs binaires de sortie des N pixels de la ligne sont lues simultanément, via les pistes conductrices CLₙ, par les circuits de filtrage couplés aux pistes CLₙ.

Par ailleurs, à chaque période T_{OSR}, par exemple pendant la période T_{RD1} de lecture de la première ligne de pixels du capteur, une phase, que l'on appellera ci-après phase de rétroaction, est mise en oeuvre simultanément dans tous les groupes de pixels interconnectés du capteur. Au cours de la phase de rétroaction, dans chacun des pixels du groupe de pixels interconnectés, le signal de sortie du convertisseur analogique-numérique basse résolution du pixel (c'est-à-dire le signal de sortie de la bascule 104 du pixel) est converti en un signal analogique et soustrait au signal intégré par la photodiode du pixel (via le circuit 106 du pixel). De plus, lors de cette phase de rétroaction, un signal représentatif du signal intégré dans la photodiode du pixel amont du groupe (le pixel P_{m,n} dans cet exemple) est injecté dans la photodiode du pixel aval du groupe (le pixel P_{m,n+1} dans cet exemple), via le circuit de liaison 401 du pixel aval.

La figure 5 est un chronogramme illustrant plus en détail le déroulement de la phase de rétroaction. Plus particulièrement, la figure 5 représente schématiquement l'évolution, en fonction du temps, des signaux de commande φ1, φ2 et φ3 (communs à tous les pixels du capteur) des circuits 106 et 401 des pixels du capteur, pendant la phase de rétroaction.

Dans l'exemple représenté, lors d'une phase de pré-charge préalable à la phase de rétroaction proprement dite, les signaux φ1 et φ2 sont mis à l'état haut, et le signal φ3 est mis à l'état bas. Il en résulte que, dans tous les pixels du capteur, les transistors 111 et 411 sont à l'état non passant. Ainsi, dans tous les pixels du capteur, des charges positives (trous) s'accumulent sous la grille du transistor 113, et des charges négatives (électrons) s'accumulent sous la grille du transistor NMOS 413.

A un instant t1 de début de la phase de rétroaction, les signaux φ1 et φ3 sont respectivement mis à l'état bas et à l'état haut, le signal φ2 étant maintenu à l'état haut. Il en résulte que, dans tous les pixels du capteur, une quantité de charges positives Q_{DAC} ≈ Cₒₓ₁₁₃*W₁₁₃*L₁₁₃*(V_{b1}-V_{b2}), isolée du noeud d'application du signal φ1, reste piégée sous la grille du transistor 113. De plus, dans chaque groupe de pixels interconnectés du capteur, dans le pixel amont du modulateur sigma-delta d'ordre 2 (le pixel P_{m,n} dans cet exemple), une quantité de charges négatives Q_{A} proportionnelle à V_{pixB}-V_{b3} (approximativement égale à Cₒₓ₄₁₃*W₄₁₃*L₄₁₃*(V_{pixB}-V_{b3}), où Cₒₓ₄₁₃, W₄₁₃ et L₄₁₃ désignent respectivement la capacité surfacique définie par l'oxyde de grille du transistor 413, la largeur de grille du transistor 413, et la longueur de grille du transistor 413, et où V_{pixB} désigne le potentiel du noeud K du pixel aval, c'est-à-dire du pixel P_{m,n+1} dans cet exemple), isolée du noeud d'application du signal φ3, reste piégée sous la grille du transistor 413. En outre, dans le pixel aval du modulateur d'ordre 2 (le pixel P_{m,n+1} dans cet exemple), une quantité de charges négatives Q_{B} proportionnelle à V_{pixA}-V_{b3} (approximativement égale à Cₒₓ₄₁₃*W₄₁₃*L₄₁₃*(V_{pixA}-V_{b3}), où V_{pixA} désigne le potentiel du noeud K du pixel amont, c'est-à-dire du pixel P_{m,n} dans cet exemple), isolée du noeud d'application du signal φ3, reste piégée sous la grille du transistor 413.

A un instant t2 postérieur à l'instant t1, le signal φ2 est mis à l'état bas, les signaux φ1 et φ3 étant maintenus respectivement à l'état bas et à l'état haut. Il en résulte que, dans chaque pixel du capteur, si la sortie de la bascule 104 du pixel est à l'état bas (Vₚᵢₓ < V_{ref}), le transistor 111 du pixel est rendu passant, ce qui provoque le transfert, sur le noeud K du pixel, du paquet de charges Q_{DAC} stocké sous la grille du transistor 113 du pixel. Si en revanche la sortie de la bascule 104 est à l'état haut (Vₚᵢₓ > V_{ref}), le transistor 111 reste non passant, et aucune charge n'est injectée dans la photodiode par le circuit 106. De plus, dans chaque groupe de pixels du capteur, le transistor 411 du pixel aval du modulateur sigma-delta d'ordre 2 (le pixel P_{m,n+1} dans l'exemple représenté) est rendu passant, ce qui provoque le transfert, sur le noeud K du pixel aval, de la quantité de charges négatives stockée sous la grille du transistor 413 de ce pixel (proportionnelle au signal intégré dans la photodiode du pixel amont, représentatif de l'erreur de quantification du modulateur d'ordre 1 du pixel amont). Le signal de configuration m_{B} étant à l'état bas, le transistor 411 du pixel amont du modulateur d'ordre 2 (le pixel P_{m,n} dans cet exemple) reste bloqué, et aucune charge n'est injectée dans la photodiode de ce pixel via le circuit 401 de ce pixel.

A un instant t3 postérieur à l'instant t2, marquant la fin de la phase de rétroaction, le signal φ2 est à nouveau mis à l'état haut de façon à isoler, dans chaque pixel du capteur, les circuits d'injection de charges 106 et 401 du noeud K du pixel. A l'instant t3 ou à un instant t4 postérieur à l'instant t3, les signaux φ1 et φ3 peuvent être remis respectivement à l'état haut et à l'état bas, de façon à recharger les circuits 106 et 401 en vue de la prochaine phase de rétroaction.

On notera que dans l'exemple de la figure 4, les coefficients du modulateur d'ordre 2 peuvent être fixés par la taille des transistors 113 et 413 des circuits d'injection de charges 106 et 401. Ainsi, les transistors 113 et 413 peuvent avoir des capacités de stockage de charges distinctes. En particulier, la capacité de stockage de charges du transistor 413 peut être choisie relativement élevée, de façon que, lors de la phase de rétroaction, la quantité de charges négatives injectée dans la photodiode 100 du pixel aval du modulateur d'ordre 2, par le circuit de liaison 401 de ce pixel, soit prépondérante devant la quantité de charges photogénérées dans la photodiode de ce pixel à chaque période T_{OSR}.

Outre les avantages déjà décrits en relation avec les figures 1, 2, 3A et 3B, le mode de réalisation de la figure 4 présente l'avantage de permettre, sans augmenter significativement l'encombrement et la complexité des pixels du capteur, de réduire de façon significative la fréquence de balayage des pixels par rapport à un capteur du type décrit en relation avec la figure 1 (à temps d'acquisition d'image identiques, à résolutions de quantification identiques, et à niveaux de bruit de quantification identiques).

Des modes de réalisation particuliers ont été décrits. Diverses variantes et modifications apparaîtront à l'homme de l'art.

En particulier, les modes de réalisation décrits ne se limitent pas à l'exemple particulier de la figure 4 dans lequel chaque pixel comprend un modulateur sigma-delta d'ordre 1, les pixels étant interconnectés par groupes de deux pixels, les modulateurs des pixels d'un même groupe pouvant être reliés pour former un modulateur d'ordre 2. Plus généralement, selon un aspect des modes de réalisation décrits, chaque pixel comprend un modulateur d'ordre p égal ou supérieur à 1, et les pixels sont interconnectés par groupes de q pixels, avec q égal ou supérieur à 2, les pixels d'un même groupe pouvant être reliés pour former un modulateur d'ordre p*q.

De plus, les modes de réalisation décrits ne se limitent pas aux exemples particuliers de circuits de rétroaction 106 et de liaison 401 décrits en relation avec la figure 4. En particulier, l'homme du métier saura adapter les modes de réalisation décrits pour remplacer les circuits de rétroaction 106 et de liaison 401 décrits en relation avec la figure 4 par d'autres circuits, par exemple des circuits adaptés à recharger en tension, respectivement décharger en courant, le noeud K du pixel.

De plus, les modes de réalisation décrits ne se limitent pas au cas particulier décrit ci-dessus dans lequel, dans chaque pixel du capteur, l'intégrateur analogique du modulateur sigma-delta du pixel comprend la photodiode du pixel. A titre de variante, une ou plusieurs capacités supplémentaires spécifiques peuvent être prévues dans chaque pixel pour former l'intégrateur analogique du modulateur sigma-delta du pixel.

En outre, les modes de réalisation décrits ne se limitent pas à l'exemple particulier de convertisseur analogique-numérique basse résolution décrit ci-dessus, comportant un comparateur 102 et une bascule 104 connectée en sortie du comparateur 102. A titre de variante, le convertisseur analogique-numérique basse-résolution peut être constitué par un comparateur 1-bit directement piloté par un signal d'horloge, ou, plus généralement, par tout autre circuit de conversion analogique-numérique basse-résolution adapté.

## Revendications

1. Capteur d'images CMOS comportant une pluralité de pixels (P_{m,n}) comprenant chacun :
une photodiode (100) ;
un modulateur sigma-delta d'ordre p, avec p entier supérieur ou égal à 1, adapté à fournir un signal numérique binaire représentatif du niveau d'éclairement de la photodiode ; et
un circuit configurable de liaison (401) permettant de relier le modulateur sigma-delta du pixel (P_{m,n}) à un modulateur sigma-delta d'un autre pixel, de façon que les modulateurs des deux pixels forment ensemble un modulateur sigma-delta d'ordre supérieur à p.

2. Capteur selon la revendication 1, dans lequel les pixels (P_{m,n}) sont répartis par groupes de q pixels, avec q entier supérieur ou égal à 2, les pixels d'un même groupe étant interconnectés et les circuits de liaison (401) des pixels d'un même groupe pouvant être configurés pour relier les modulateurs d'ordre p des pixels du groupe de façon que ces modulateurs forment ensemble un modulateur sigma-delta d'ordre q*p.

3. Capteur selon la revendication 1 ou 2, dans lequel dans chaque pixel (P_{m,n}), le modulateur sigma-delta d'ordre p du pixel comprend un intégrateur analogique comportant la photodiode (100) du pixel.

4. Capteur selon la revendication 3, dans lequel, dans chaque pixel (P_{m,n}), le modulateur sigma-delta d'ordre p comprend un convertisseur analogique-numérique (102, 104) d'un signal analogique de sortie (Vₚᵢₓ) de l'intégrateur analogique du pixel.

5. Capteur selon la revendication 4, dans lequel, dans chaque pixel (P_{m,n}), le convertisseur analogique-numérique comprend un comparateur (102) comparant ledit signal de sortie (Vₚᵢₓ) à un signal de référence (V_{ref}).

6. Capteur selon la revendication 4 ou 5, dans lequel, dans chaque pixel (P_{m,n}), le modulateur sigma-delta d'ordre p comprend un circuit (106) de rétroaction reliant un noeud (Q) de sortie du convertisseur analogique-numérique (102, 104) à un noeud (K) de l'intégrateur analogique du pixel.

7. Capteur selon la revendication 6, dans lequel, dans chaque pixel (P_{m,n}), le circuit de rétroaction (106) est adapté à injecter une quantité de charges (Q_{DAC}) prédéterminée dans l'intégrateur analogique du pixel.

8. Capteur selon la revendication 7, dans lequel lesdites charges (Q_{DAC}) sont de signe opposé à celui des charges photogénérées accumulées dans la photodiode (101) du pixel.

9. Capteur selon l'une quelconque des revendications 6 à 8, dans lequel, dans chaque pixel (P_{m,n}), le circuit de rétroaction (106) comprend des premier (111), deuxième (113) et troisième (115) transistors MOS à canal P en série entre le noeud (K) de l'intégrateur analogique du pixel, et un noeud d'application d'un premier signal de commande (φ1).

10. Capteur selon la revendication 9, dans lequel, dans chaque pixel (P_{m,n}), les grilles de commande des deuxième (113) et troisième (115) transistors MOS à canal P sont reliées respectivement à des premier (V_{b2}) et deuxième (V_{b1}) potentiels de polarisation.

11. Capteur selon la revendication 9 ou 10, dans lequel, dans chaque pixel (P_{m,n}), la grille de commande du premier (111) transistor MOS à canal P est reliée à un noeud d'application d'un deuxième signal de commande (φ2) et audit noeud (Q) de sortie du convertisseur analogique-numérique (102, 104) par l'intermédiaire d'une porte logique (117).

12. Capteur selon l'une quelconque des revendications 3 à 11, dans lequel, dans chaque pixel (P_{m,n}), le circuit de liaison (401) est adapté à injecter, sur un noeud (K) de l'intégrateur analogique du pixel, une quantité de charges (Q_{A}, Q_{B}) représentative d'un signal de sortie de l'intégrateur analogique d'un autre pixel (P_{m,n+1}) du capteur.

13. Capteur selon la revendication 12, dans lequel, dans chaque pixel (P_{m,n}), le circuit de liaison comprend des premier (411), deuxième (413) et troisième (415) transistors MOS à canal N en série entre le noeud (K) de sortie de l'intégrateur analogique du pixel et un noeud d'application d'un troisième signal de commande (φ3).

14. Capteur selon la revendication 13, dans lequel, dans chaque pixel (P_{m,n}), les grilles de commande des deuxième (413) et troisième (415) transistors MOS à canal N sont reliées respectivement à un troisième potentiel de polarisation (V_{b3}) et à un noeud (K) d'un intégrateur analogique d'un autre pixel (P_{m,n+1}) du capteur.

## Patentansprüche

1. Ein CMOS Bildsensor, wobei der Sensor eine Vielzahl von Pixel (P_{m,n}) aufweist, wobei jedes Folgendes aufweist:
eine Photodiode (100);
einen Sigma-Delta Modulator der Ordnung p, wobei p eine Ganzzahl ist, die größer oder gleich 1 ist, und wobei der Sigma-Delta Modulator geeignet ist ein binäres digitales Signal bereitzustellen, das repräsentativ für einen Ausleuchtungspegel der Photodiode ist;
einen konfigurierbaren Verbindungsschaltkreis (401), der die Verbindung des Sigma-Delta Modulators des Pixels (P_{m,n}) mit dem Sigma-Delta Modulator eines weiteren Pixel ermöglicht, so dass die Modulatoren der zwei Pixel miteinander einen Sigma-Delta Modulator einer Ordnung bilden, die größer ist als p.

2. Der Sensor nach Anspruch 1, wobei die Pixel (P_{m,n}) in Gruppen von q Pixel verteilt sind, wobei q eine Ganzzahl ist, die größer oder gleich 2 ist, wobei die Pixel einer selben Gruppe miteinander verbunden sind, und wobei die Schaltkreise (401) zum Verbinden der Pixel einer selben Gruppe, geeignet sind konfiguriert zu sein die Modulatoren der Ordnung p der Pixel in der Gruppe zu verbinden, so dass die Modulatoren zusammen einen Sigma-Delta Modulator der Ordnung q*p bilden.

3. Der Sensor nach Anspruch 1 oder 2, wobei in jedem Pixel (P_{m,n}) des Sigma-Delta Modulators der Ordnung p der Pixel einen analogen Integrator aufweist, der die Photodiode (100) der Pixel aufweist.

4. Der Sensor nach Anspruch 3, wobei in jedem Pixel (P_{m,n}) der Sigma-Delta Modulator der Ordnung p einen analog-zu-digital Konverter (102, 104) eines analogen Ausgangssignals (Vₚᵢₓ) des analogen Integrators der Pixel aufweist.

5. Der Sensor nach Anspruch 4, wobei in jedem Pixel (P_{m,n}), der analog-zu-digital Konverter einen Komparator (102) aufweist, der das Ausgangssignal (Vₚᵢₓ) mit einem Referenzsignal (V_{ref}) vergleicht.

6. Der Sensor nach Anspruch 4 oder 5, wobei in jedem Pixel (P_{m,n}), der Sigma-Delta Modulator der Ordnung p einen Rückmeldungsschaltkreis (106) aufweist, der einen Ausgangsknoten (Q) des analog-zu-digital Konverters (102, 104) mit einem Knoten (K) des analogen Integrators des Pixels verbindet.

7. Der Sensor nach Anspruch 6, wobei in jedem Pixel (P_{m,n}), der Rückmeldungsschaltkreis (106) geeignet ist eine vorbestimmte Menge an Ladung (Q_{DAC}) in den analogen Integrator des Pixels einzuspeisen.

8. Der Sensor nach Anspruch 7, wobei die Ladungen (Q_{DAC}) ein Vorzeichen aufweisen, das umgekehrt zu dem der photoerzeugten Ladungen ist, die in der Photodiode (101) des Pixels gespeichert sind.

9. Der Sensor nach einem der Ansprüche 6 bis 8, wobei in jedem Pixel (P_{m,n}), der Rückmeldungsschaltkreis (106) einen ersten (111), einen zweiten (113) und einen dritten (155) P-Kanal MOS Transistor aufweist, die in Reihe zwischen den Knoten (K) des analogen Integrators des Pixels und einen Knoten einer Applikation eines ersten Steuersignals (Φ1) geschaltet sind.

10. Der Sensor nach Anspruch 9, wobei in jedem Pixel (P_{m,n}), die Steuer-Gates des zweiten (113) und des dritten (115) P-Kanal MOS Transistors entsprechend mit einem ersten (V_{b2}) und einem zweiten (V_{b1}) Bias Potential verbunden sind.

11. Der Sensor nach Anspruch 9 oder 10, wobei in jedem Pixel (P_{m,n}), das Steuer-Gate des ersten (111) P-Kanal MOS Transistors mit einem Knoten einer Applikation eines zweiten Steuersignals (Φ2) und mit dem Ausgangsknoten (Q) des analog-zu-digital Konverters (102, 104) über ein logisches Gate (117) verbunden ist.

12. Der Sensor nach einem der Ansprüche 3 bis 11, wobei in jedem Pixel (P_{m,n}), der Verbindungsschaltkreis (401) geeignet ist in einen Knoten (K) des analogen Integrators des Pixels, eine Menge an Ladungen (Q_{A}, Q_{B}) einzuspeisen, die repräsentativ für ein Ausgangssignal des analogen Integrators eines weiteren Pixels (P_{m,n+1}) des Sensors ist.

13. Der Sensor nach Anspruch 12, wobei in jedem Pixel (P_{m,n}), der Verbindungsschaltkreis erste (411), zweite (413) und dritte (415) N-Kanal MOS Transistoren aufweist, die in Reihe zwischen den Ausgangsknoten (K) des analogen Integrators des Pixels und einen Knoten einer Applikation eines dritten Steuersignals (Φ3) geschaltet sind.

14. Der Sensor nach Anspruch 13, wobei in jedem Pixel (P_{m,n}), die Steuer-Gates des zweiten (413) und des dritten (415) N-Kanal MOS Transistors entsprechend mit einem dritten Bias Potential (V_{b3}) und mit einem Knoten (K) eines analogen Integrators eines weiteren Pixels (P_{m,n+1}) des Sensors verbunden sind.

## Claims

1. A CMOS image sensor comprising a plurality of pixels (P_{m,n}), each comprising:
a photodiode (100);
a sigma-delta modulator of order p, p being an integer greater than or equal to 1, capable of delivering a binary digital signal representative of the illumination level of the photodiode; and
a configurable connection circuit (401) enabling to couple the sigma-delta modulator of the pixel (P_{m,n}) to a sigma-delta modulator of another pixel, so that the modulators of the two pixels form with each other a sigma-delta modulator of order greater than p.

2. The sensor of claim 1, wherein the pixels (P_{m,n}) are distributed in groups of q pixels, q being an integer greater than or equal to 2, the pixels of a same group being interconnected and the circuits (401) for connecting the pixels of a same group being capable of being configured to couple the modulators of order p of the pixels in the group so that the modulators form together a sigma-delta modulator of order q*p.

3. The sensor of claim 1 or 2, wherein in each pixel (P_{m,n}), the sigma-delta modulator of order p of the pixel comprises an analog integrator comprising the photodiode (100) of the pixel.

4. The sensor of claim 3, wherein, in each pixel (P_{m,n}), the sigma-delta modulator of order p comprises an analog-to-digital converter (102, 104) of an analog output signal (Vₚᵢₓ) of the analog integrator of the pixel.

5. The sensor of claim 4, wherein, in each pixel (P_{m,n}), the analog-to-digital converter comprises a comparator (102) comparing said output signal (Vₚᵢₓ) with a reference signal (V_{ref}).

6. The sensor of claim 4 or 5, wherein, in each pixel (P_{m,n}), the sigma-delta modulator of order p comprises a feedback circuit (106) connecting an output node (Q) of the analog-to-digital converter (102, 104) to a node (K) of the analog integrator of the pixel.

7. The sensor of claim 6, wherein, in each pixel (P_{m,n}), the feedback circuit (106) is capable of injecting a predetermined quantity of charges (Q_{DAC}) into the analog integrator of the pixel.

8. The sensor of claim 7, wherein said charges (Q_{DAC}) have a sign opposite to that of the photogenerated charges stored in the photodiode (101) of the pixel.

9. The sensor of any of claim 6 to 8, wherein, in each pixel (P_{m,n}), the feedback circuit (106) comprises first (111), second (113), and third (155) P-channel MOS transistors series-connected between the node (K) of the analog integrator of the pixel, and a node of application of a first control signal (φ1).

10. The sensor of claim 9, wherein, in each pixel (P_{m,n}), the control gates of the second (113) and third (115) P-channel MOS transistors are respectively coupled to first (V_{b2}) and second (V_{b1}) bias potentials.

11. The sensor of claim 9 or 10, wherein, in each pixel (P_{m,n}), the control gate of the first (111) P-channel MOS transistor is coupled to a node of application of a second control signal (φ2) and to said output node (Q) of the analog-to-digital converter (102, 104) via a logic gate (117).

12. The sensor of any of claim 3 to 11, wherein, in each pixel (P_{m,n}), the connection circuit (401) is capable of injecting, onto a node (K) of the analog integrator of the pixel, a quantity of charges (Q_{A}, Q_{B}) representative of an output signal of the analog integrator of another pixel (P_{m,n+1}) of the sensor.

13. The sensor of claim 12, wherein, in each pixel (P_{m,n}), the connection circuit comprises first (411), second (413), and third (415) N-channel MOS transistors series-connected between the output node (K) of the analog integrator of the pixel and a node of application of a third control signal (φ3).

14. The sensor of claim 13, wherein, in each pixel (P_{m,n}), the control gates of the second (413) and third (415) N-channel MOS transistors are respectively coupled to a third bias potential (V_{b3}) and to a node (K) of an analog integrator of another pixel (P_{m,n+1}) of the sensor.
